# EUROPÄISCHE PATENTSCHRIFT

(11) **EP 0 581 823 B1**
(45) Veröffentlichungstag und Bekanntmachung des Hinweises auf die Patenterteilung: **31.07.1996**
(21) Anmeldenummer: 92909035.5
(22) Anmeldetag: 17.04.1992
(51) Int. Cl.: H05K 3/42, C23C 18/22, C25D 5/54

(54) **MITTEL ZUR SELEKTIVEN AUSBILDUNG EINER DÜNNEN OXIDIERENDEN SCHICHT**
MEANS FOR THE SELECTIVE FORMATION OF A THIN OXIDISING LAYER
AGENT POUR LA FORMATION SELECTIVE D'UNE COUCHE MINCE OXYDANTE

(30) Priorität: 26.04.1991 DE 4113653; 26.04.1991 DE 4113654
(43) Veröffentlichungstag der Anmeldung: 09.02.1994
(73) Patentinhaber: Blasberg-Oberflächentechnik GmbH, D-42699 Solingen (DE)
(72) Erfinder: HUPE, Jürgen, D-4018 Langenfeld (DE); ALTGELD, Werner, D-5650 Solingen 1 (DE); KRONENBERG, Walter, D-5000 Köln 80 (DE); FIX, Sabine, D-5603 Wülfrath (DE)
(74) Vertreter: Werner, Hans-Karsten, Dr.Dipl.-Chem.
(86) Internationale Anmeldenummer: EP9200864
(87) Internationale Veröffentlichungsnummer: WO9220204

(56) Entgegenhaltungen:
- WO-A-91/03920

## Beschreibung

Gegenstand der vorliegenden Erfindung ist ein Mittel zur selektiven Ausbildung einer dünnen oxidierenden Schicht mittels Permanganat auf nicht verkupferten Teilen von kupferbeschichtete Teile aufweisendem Trägermaterial aus Polymeren, Glasfasern und Keramik, sowie seine Verwendung.

Bei der Herstellung von gedruckten Schaltungen bestehen die Trägermaterialien häufig aus glasfaserverstärkten Polymermaterialien wie zum Beispiel Epoxidharzen, oder Keramik, welche im allgemeinen beidseitig außen mit dünnen Kupferfolien kaschiert sind. Bei Mehrlagenschaltungen finden sich derartige dünne Kupferfolien auch im Inneren der Trägermaterialien.

Aus der DE-PS 38 06 884 der Anmelderin ist ein Verfahren bekannt geworden zur Herstellung von durchkontaktierten gedruckten Schaltungen, bei dem die nicht mit einer Metallkaschierung überzogenen Bereiche des polymeren oder keramischen Trägermaterials, insbesondere die Bohrlochwandungen, mit einem leitfähigen Polymeren aus Pyrrol, Furan, Thiophen oder Derivaten überzogen werden. Um diese leitfähigen Polymerschichten erzeugen zu können, ist eine Vorbehandlung der Flächen des Trägers mit einem oxidierend wirkenden Bad notwendig. Vorzugsweise wird hierfür Permanganat eingesetzt, und zwar im pH-Bereich zwischen 1 und 14. Ein besonderer Vorteil des dort beschriebenen Verfahrens ist die Selektivität der Aufbringung der leitfähigen Polymerschicht. Insbesondere bei Verwendung von alkalischem Permanganat entsteht diese nämlich nur auf den nicht mit Kupfer beschichteten Teilen des Trägermaterials. Spätere genauere Untersuchungen haben gezeigt, daß bei dieser Vorbehandlung mit einem oxidierend wirkenden Bad dünne oxidierende Schichten ausgebildet werden, und zwar insbesondere auf den Polymeren, jedoch auch auf den Glasfasern sowie der Keramik. Hierbei sind jedoch erhebliche graduelle Unterschiede festgestellt worden. So erhält man auf den Polymerschichten einwandfrei wirkende dünne oxidierende Schichten, unabhängig vom pH-Wert der eingesetzten Permanganatlösung, während insbesondere durch den Bohrvorgang und die Oxidation der Polymerschicht freigelegte Glasfaserteile sehr unterschiedlich belegt werden. Alkalische Permanganatlösungen bilden auf solchen freiwerdenden Glasfaserteilchen kaum ausreichend wirksame oxidierende Schichten aus, während saure Permanganatlösungen sowohl die Polymerschicht als auch alle Arten von Glasoberflächen und Keramik einwandfrei mit einer oxidierenden Schicht belegen. Dies gilt insbesondere für die Durchführung des Verfahrens in horizontalen Durchlaufanlagen. Saure Permanganatlösungen wirken bekanntlich stärker oxidierend und führen daher auch zu einer unerwünschten Oxidation der Kupferflächen. Die Verwendung von stark sauren Permanganatlösungen führt somit zu einer verschlechterten Selektivität, so daß sich bei der späteren Kontaktierung mit dem polymerisierbaren Monomeren auch auf dem Kupfer unerwünschte Polymerschichten ausbilden. Bei der nachträglichen Metallisierung, insbesondere der nachträglichen Verkupferung, entstehen auf derartigen Kupferschichten weniger gut haftende Metallschichten.

Aus WO-A-91 03 920 ist bekannt, kupferkaschiertes und mit Bohrungen versehenes Trägermaterial aus glasfaser verstärktem Epoxidharz mit einem Mittel zu behandeln, welches aus einer mit Schwefelsäure angesäuerten Kaliumpermanganatlösung besteht.

Die Erfindung hat sich somit die Aufgabe gestellt, ein Mittel zur Verfügung zu stellen, welches in der Lage ist, selektiv eine dünne oxidierende Schicht auf Polymeren, Glasfasern und Keramik auszubilden, nicht jedoch auf Kupfer.

Diese Aufgabe wird überraschenderweise gelöst durch ein Mittel mit den Merkmalen des Anspruches 1. Das Mittel besteht aus einer wäßrigen Kaliumpermanganatlösung, die mittels Sulfonsäure, vorzugsweise Methansulfonsäure auf einen pH-Wert von 6,0 bis 0, vorzugsweise 5,0 bis 2,0 eingestellt ist. Vorzugsweise enthält diese Lösung 10 bis 100 g/l Kaliumpermanganat. Weitere geeignete Sulfonsäuren sind beispielsweise Sulfo-bernsteinsäure und Isäthionsäure.

Das erfindungsgemäße Mittel wirkt in zweierlei Weise selektiv. Im höheren pH-Bereich bis etwa pH 2,5 wird von dem erfindungsgemäßen Mittel die Kupferschicht nicht oxidiert oder zumindest nicht so, daß sich auf ihr eine leitfähige Polymerschicht ausbildet. Stärker saure Sulfonsäure-Permanganatlösungen führen zwar zu einer gewissen Oxidation der Kupferfläche, jedoch kann diese durch Behandlung mit verdünnter Schwefelsäure oder mit schwefelsaurer Natriumperoxodisulfatlösung wieder entfernt bzw. inaktiviert werden.

Besondere Vorteile bringt das erfindungsgemäße Mittel bei der Herstellung von Leiterplatten in einer horizontal arbeitenden Durchlaufanlage, wie es beispielsweise in der DE-A-39 31 003 und der EP-A-0 417 750 beschrieben ist. Insbesondere bei den kürzeren Behandlungszeiten in einer horizontal arbeitenden Durchlaufanlage bilden sich auf den frisch freigesetzten Flächen der Glasfasern ungenügend wirksame oxidierende Schichten aus. Mit Hilfe der erfindungsgemäßen sauren Permanganatlösung kann dieses Problem leicht gelöst werden. Ein weiterer Vorteil des erfindungsgemäßen Mittels ist, daß es bei niedrigerer Temperatur eingesetzt werden kann als alkalische Permanganatlösung. Dies erleichtert die Handhabung und senkt die Energiekosten.

Schließlich hat sich als besonders vorteilhaft erwiesen, daß die erfindungsgemäßen Mittel besonders günstig eingesetzt werden können zusammen mit dem kombinierten Katalysator- und Fixierbad gemäß der deutschen Patentanmeldung P 41 13 653.5 der Anmelderin vom gleichen Tage. Dieses kombinierte Katalysator- und Fixierbad zur Herstellung von leitfähigen, anschließend metallisierbaren Polymerschichten aus Pyrrol und/oder Pyrrolderivaten besteht aus einer sauren wäßrigen Lösung von Pyrrol und/oder seinen Derivaten, Phosphorsäure und einem puffernden Zusatz, welcher den pH-Wert auf pH 1 bis 5, vorzugsweise pH 2 bis 3 einstellt. Durch dieses Bad können die Schritte des Eintauchens in eine Lösung von Pyrrol und/oder seinen Derivaten und die anschließende sauer Fixierung zu einem Reaktionsschritt zusammengefaßt werden.

Eine besonders stabile Lösung, die dennoch gut als kombiniertes Katalysator- und Fixierbad eingesetzt werden kann, enthält 1 bis 10 Gew.-% Pyrrol und/oder Pyrrolderivate und etwa die halbe Gewichtsmenge Phosphorsäure sowie als puffernden Zusatz N-Methylpyrrolidon und/oder Borax oder Citrat.

Das kombinierte Katalysator- und Fixierbad weist den Vorteil auf, wochenlang stabil zu sein und dabei dennoch seine gute Wirksamkeit zu behalten. Das kombinierte Katalysator- und Fixierbad weist nach wie vor den Vorteil auf, bei Verwendung von Permanganat als Oxidationsmittel selektiv nur die nicht verkupferten Teile des Trägermaterials leitfähig zu beschichten. Auf alle Fälle kommt es nicht zu unerwünschten festen Ablagerungen von polymerisiertem Pyrrol auf bereits kupferbeschichteten Teilen des Trägermaterials. Das kombinierte Katalysator- und Fixierbad kann mit sehr gutem Erfolg in einer horizontal arbeitenden Durchlaufanlage eingesetzt werden.

In den nachfolgenden Beispielen sind erfindungsgemäße Mittel zur selektiven Ausbildung einer dünnen oxidierenden Schicht mittels Permanganat sowie ihre Anwendungen in der Praxis näher erläutert.

### Beispiel 1

Doppelseitig kupferkaschiertes Leiterplattenbasismaterial aus glasfaserverstärktem Epoxidharz wird in der üblichen Weise gebohrt und mechanisch gereinigt. Danach wird das Substrat ca. 3 Minuten in einer handelsüblichen Konditionierlösung (zum Beispiel BLASOLIT DMS 2) bei 60°C behandelt und anschließend gespült. Nun erfolgt die Behandlung in einer erfindungsgemäßen Lösung von 50 g/l Kaliumpermanganat, die mit Methansulfonsäure auf pH 4,5 eingestellt wird. Unter leichter Bewegung wird die Leiterplatte bei 80°C 3 Minuten dieser Lösung ausgesetzt und anschließend gründlich gespült. (Wird diese Behandlung zum Beispiel horizontal in einer Durchlaufanlage durchgeführt, reduziert sich die Behandlungszeit auf etwa 1 Minute.)

Im Folgeschritt wird die Leiterplatte unter leichter Bewegung in eine wäßrige Lösung getaucht, die 8 bis 10 Gew.-% Pyrrol und 25 Gew.-% N-Methylpyrrolidon enthält. Nach 1 Minute Verweilzeit wird das Substrat entnommen und in eine saure Lösung (zum Beispiel 10%-ige Schwefelsäure oder Methansulfonsäure) gebracht. Nach ca. 1 Minute wird die Leiterplatte gespült und in einer 10%-igen Schwefelsäurelösung dekapiert.

Daran anschließend erfolgt die saure Verkupferung in einem handelsüblichen Elektrolyten (zum Beispiel CUPROSTAR LP-1 der Anmelderin) bei 2 A/dm² während 10 Minuten. Anschließend sind die Bohrungen mit einer gleichmäßigen, geschlossenen und haftfesten Kupferschicht von ca. 4 bis 5 µm durchkontaktiert. Die auf dem Kaschierungskupfer abgeschiedene Kupferschicht weist ebenfalls eine sehr gute Haftung auf. Die Leiterplatte wird dann gemäß der üblichen Methoden weiterbearbeitet.

### Beispiel 2

Statt der doppelseitigen Schaltung wird ein Multilayer verwendet, und die 50 g/l Kaliumpermanganat enthaltende Lösung wird mit Methansulfonsäure auf pH 2,0 eingestellt. Nach einer dreiminütigen Behandlung bei 60°C in dieser Lösung wird gespült und die Platine in einer wäßrigen Lösung von 10% Schwefelsäure + 10 g/l Natriumperoxodisulfat nachbehandelt. Im übrigen verläuft, nachdem die Platten nochmals gespült werden, der Arbeitsgang wie zuvor beschrieben ab. Das Ergebnis ist qualitativ gleichwertig.

### Beispiel 3

Es wird wiederum eine Multilayer-Leiterplatte aus glasfaserverstärktem Epoxidmaterial verwendet. Der Arbeitsablauf entspricht Beispiel 1 mit der Ausnahme, daß eine Kaliumpermanganatlösung von 50 g/l und 30 g/l Borsäure mit Methansulfonsäure auf pH 3,5 eingestellt wird. Die Behandlung erfolgt bei 70°C während 3 Minuten. Anschließend wird kurz in einer 5%-igen Schwefelsäurelösung dekapiert und gespült. Danach erfolgt die Behandlung in einer sauren Lösung von 2% Pyrrol, 2% Phosphorsäure und 20 g/l Borax bei Raumtemperatur. Nach 2 Minuten wird die Platte gespült, in Schwefelsäue (5%) dekapiert, gespült und getrocknet. Anschließend wird im Sieb- oder Photodruck das Leiterbild Lay-Out erstellt. Danach wird die Leiterplatte zwecks Durchkontaktierung und Leiterbildaufbau in einem Durchgang weiterverarbeitet.

Das Substrat wird dazu zunächst 5 Minuten in einer handelsüblichen sauren Reinigerlösung bei 25°C behandelt. Nach einem Spülprozeß werden die Kupferflächen in einer Lösung von 50 ml/l Wasserstoffperoxid (35%-ig) und 100 ml/l Schwefelsäure während 30 Sekunden bei 30°C aktiviert. Dann wird gespült und in einer 5%-igen Schwefelsäurelösung dekapiert, darauf folgend in einem handelsüblichen Kupferbad, zum Beispiel CUPROSTAR LP-1, galvanisch auf die gewünschte Kupferschichtstärke (zum Beispiel 25 µm) aufgekupfert. Man erhält eine haftfeste, geschlossene Kupferhülse in der Bohrung, die allen üblichen Anforderungen ausgezeichnet genügt. Die Haftung von Kupfer auf Kupfer (Kaschierung und Innenlagen bei Multilayern) ist sehr gut.

Die Weiterbehandlung bzw. -verarbeitung der Leiterplatte erfolgt in der üblichen, jedem Fachmann bekannten Art und Weise.

### Beispiel 4

Doppelseitige kupferkaschierte Leiterplatten aus glasfaserverstärktem Epoxidharz werden in der üblichen Weise gebohrt und mechanisch gereinigt. Der Durchkontaktierungsprozeß wird anschließend in einer horizontalen Durchlaufanlage mit einem Vorschub von 1,7 m/min durchgeführt. Die Platten wurden dabei zunächst in der Anlage gebürstet, mit Ultraschall zur Reinigung des Bohrloches vom Bohrmehl behandelt und einer Natriumperoxodisulfat-Schwefelsäurelösung angeätzt. Anschließend wurden die Substrate für 15 Sekunden in einer handelsüblichen Konditionierlösung behandelt, gespült und dann durch eine 50 g/l KMnO₄ enthaltende Lösung, die mit Methansulfonsäure auf einen pH-Wert von 3,0 eingestellt worden war, geführt. Die Verweilzeit betrug 52 Sekunden bei einer Temperatur von 70°C. Daran anschließend wurde gespült und durch eine 5%-ige Schwefelsäurelösung gefahren. Nach einer weiteren Spülkaskade wurden die Platten nun durch eine Katalysatorlösung mit 10% Pyrrol und 30% N-Methylpyrrolidon während 40 Sekunden bei Raumtemperatur geleitet. Direkt daran schließt sich eine saure Behandlungsstufe mit 5%-iger Schwefelsäure während 30 Sekunden an. Nach erneutem Spülvorgang und einer weiteren Schwefelsäure (5%)-Dekapierung durchliefen die Leiterplatten Module zur horizontalen galvanischen Verkupferung. Während einer Durchlaufzeit von 4 Minuten, 40 Sekunden bei einer mittleren Stromdichte von ca. 4,8 A/dm² wurden die Leiterplatten in einem handelsüblichen Elektrolyten (CUPROSTAR LP-1) aufgekupfert. Anschließend wurde gespült und getrocknet. Bei Durchführung des sogenannten Durchlichttests wurde eine vollkommene Bedeckung der Bohrlochwandung festgestellt. Danach waren Harz und Glas gleichmäßig, vollständig und haftfest, also fehlerfrei, belegt.

### Vergleichsbeispiel 1

Wird der gesamte Vorgang, wie in Beispiel 4 beschrieben, wiederholt mit der Ausnahme, daß eine Kaliumpermanganatlösung mit 60 g/l KMnO₄ und 50 g/l NaOH bei 90°C anstatt der sauren Permanganatlösung verwendet wird, so erhält man ebenfalls eine gleichmäßige, haftfeste Verkupferung. Im Durchlichttest können allerdings kleine, wenn auch nicht gravierende Fehlstellen bei der Glasbelegung festgestellt werden.

### Vergleichsbeispiel 2

Wird der gesamte Vorgang wie in Vergleichsbeispiel 1 wiederholt, aber bei einer Temperatur des alkalischen Kaliumpermanganats von 70°C, so sind nach der galvanischen Vorverkupferung deutliche Fehlstellen erkennbar, die bevorzugt die Glasfasern betreffen.

Aus den Vergleichsbeispielen 1 und 2 geht hervor, daß erfindungsgemäß bei niedrigerer Temperatur mit methansulfonsaurer Permanganatlösung eine einwandfreie dünne oxidierende Beschichtung auch auf den frisch freigelegten Glasfaseroberflächen erzeugt wird, gleichzeitig jedoch die Selektivität gegenüber den Kupferflächen voll erhalten bleibt.

## Patentansprüche

1. Mittel zur selektiven Ausbildung einer dünnen oxidierenden Schicht mittels Permanganat auf nicht verkupferten Teilen von kupferbeschichtete Teile aufweisendem Trägermaterial aus Polymeren, Glasfasern und Keramik, bestehend aus einer wäßrigen Kaliumpermanganatlösung und einer Säure, dadurch gekennzeichnet, daß die Säure eine Sulfonsäure ist und der pH-Wert auf 6,0 bis 0 eingestellt ist.

2. Mittel gemäß Anspruch 1, dadurch gekennzeichnet, daß die Sulfonsäure Methansulfonsäure ist.

3. Mittel gemäß Anspruch 1 oder 2, dadurch gekennzeichnet, daß der pH-Wert 5,0 bis 2,0 ist.

4. Mittel gemäß einem der Ansprüche 1 bis 3, dadurch gekennzeichnet, daß es 10 bis 100 g/l Kaliumpermanganat enthält.

5. Mittel gemäß einem der Ansprüche 1 bis 4, dadurch gekennzeichnet, daß es 50g/l Kalium per manganat und zusätzlich 30g/l Borsäure enthält und mit Methansulfonsäure auf pH 3.5 eingestellt ist.

6. Verwendung des Mittels gemäß einem der Ansprüche 1 bis 5 zur Vorbereitung der nicht verkupferten Teile von kupferbeschichtete Teile aufweisendem Trägermaterial aus Polymeren, Glasfasern und Keramik zur anschließenden Behandlung mit einem kombinierten Katalysator- und Fixierbad zur Herstellung von leitfähigen und anschließend metallisierbaren Polymerschichten aus Pyrrol und/oder Pyrrolderivaten, wobei das kombinierte Katalysator- und Fixierbad besteht aus einer sauren und wäßrigen Lösung von Pyrrol und/oder seinen Derivaten, Phosphorsäure und einem puffernden Zusatz, welcher den pH-Wert auf pH 1 bis 5, vorzugsweise pH 2 bis 3 einstellt.

7. Verwendung gemäß Anspruch 6, dadurch gekennzeichnet, daß das Bad 1 bis 10 Gew.-% Pyrrol und/oder Pyrrolderivate, etwa die halbe Gewichtsmenge Phosphorsäure und als puffernden Zusatz N-Methylpyrrolidon und/oder Borax oder Citrat enthält.

## Claims

1. A means for the selective formation of a thin oxidizing layer with permanganate on parts which have not been copper-plated of a carrier material made of polymers, glass fibers and ceramics and comprising copper-coated parts, said means consisting of an aqueous potassium permanganate solution and an acid, characterized in that the acid is a sulfonic acid and the pH value has been adjusted to from 6.0 to zero.

2. The means according to claim 1, characterized in that the sulfonic acid is methanesulfonic acid.

3. The means according to claims 1 or 2, characterized in that the pH value is from 5.0 to 2.0.

4. The means according to anyone of claims 1 to 3, characterized in that it contains from 10 to 100 g/l of potassium permanganate.

5. The means according to anyone of claims 1 to 4, characterized in that it contains 50 g/l of potassium permanganate and, in addition thereto, 30 g/l of boric acid and that its pH value has been adjusted to 3.5 with methanesulfonic acid.

6. Use of the means according to anyone of claims 1 to 5 for the pre-treatment of the parts which have not been copper-plated of a carrier material made of polymers, glass fibers and ceramics and comprising copper-coated parts, for the subsequent treatment with a combined catalyst and fixing bath for the manufacture of conductive polymer layers of pyrrole and/or pyrrole derivatives - which layers can be subsequently metallized - , wherein the combined catalyst and fixing bath consists of an acidic and aqueous solution of pyrrole and/or its derivatives, phosphoric acid and a buffering additive which controls the pH to a value of from 1 to 5, and preferably from 2 to 3.

7. Use according to claim 6, characterized in that the bath contains from 1 to 10% by weight of pyrrole and/or pyrrole derivatives and about half the amount by weight of phosphoric acid as well as N-methylpyrrolidone and/or borax or citrate as the buffering additive.

## Revendications

1. Produit pour la formation sélective, au moyen de permanganate d'une couche mince oxydable, sur des parties non cuivrées d'un matériau porteur présentant des parties recouvertes de cuivre, ce matériau étant constitué de polymères, de fibres de verre et de céramiques, ce produit consistant en une solution aqueuse de permanganate de potassium et un acide,
caractérisé en ce que l'acide est un acide sulfonique et la valeur du pH est établie à 6,0 et 0.

2. Produit selon la revendication 1, caractérisé en ce que l'acide sulfonique est de l'acide méthane-sulfonique.

3. Produit selon la revendication 1 ou 2, caractérisé en ce que la valeur du pH est de 5,0 à 2,0.

4. Produit selon les revendications 1 à 3, caractérisé en ce qu'il comprend 10 à 100 g/l de permanganate de potassium.

5. Produit selon les revendications 1 à 4, caractérisé en ce qu'il contient 50 g/l de permanganate de potassium et additionnellement 30 g/l d'acide borique, et qu'il est établi à pH 3 à l'aide d'acide méthane-sulfonique.

6. Utilisation du produit selon l'une des revendications 1 à 5, pour préparer le produit présentant des parties non cuivrées de matériau présentant de parties recouvertes de cuivre et formé de polymères, fibres de verre et céramiques, pour le traitement consécutif avec un bain combiné catalyseur et fixateur pour l'obtention de couches de polymère conductrices et ensuite métallisables formées de pyrrole et/ ou dérivés du pyrrole,
utilisation dans laquelle le bain combiné de catalyseur et fixateur est constitué d'une solution aqueuse acide de pyrrole et/ou de ses dérivés, d'acide phosphorique et d'un additif gonflant, qui est établi à une valeur de pH de 1 à 5 de préférence 2 à 3.

7. Utilisation selon la revendication 6, cacactérisée en ce que le bain contient de 1 à 10 % en poids de pyrrole et/ou de dérivés de pyrrole, à peu près la moitié de cette teneur en poids d'acide phosphorique et, comme agent gonflant, de la N-méthylpyrrolidone et/ou du borax ou un citrate.
